Europäisches Patentamt

European Patent Office

Office européen des brevets

(11) Veröffentlichungsnummer: **0 152 735**

**A1**

(12) **EUROPÄISCHE PATENTANMELDUNG**

(21) Anmeldenummer: 85100081.0

(22) Anmeldetag: 04.01.85

(51) Int. Cl.⁴: **H 03 K 17/955**

(30) Priorität: 10.01.84 DE 3400575

(43) Veröffentlichungstag der Anmeldung: 28.08.85
Patentblatt 85/35

(84) Benannte Vertragsstaaten: **AT BE CH DE FR GB IT LI LU NL SE**

(71) Anmelder: **Feldmühle Aktiengesellschaft, Fritz-Vomfelde-Platz 4, D-4000 Düsseldorf 11 (DE)**

(72) Erfinder: **Der Erfinder hat auf seine Nennung verzichtet**

(74) Vertreter: **Uhlmann, Hans, Dr. rer.nat., Dipl.-Chem., Gladbacher Strasse 189, D-4060 Viersen 1 (DE)**

(54) **Durch Gleichspannung mittel eines kapazitiven Näherungsschalters betätigbare Ausgabevorrichtung.**

(57) Eine durch Gleichspannung mittels eines kapazitiven Näherungsschalters 67 betätigbare Ausgabevorrichtung für flüssige oder pastöse Güter weist eine Sensorschaltung mit zwei in Ruhestellung im wesentlichen synchron schwingenden Oszillatoren 79, 80 auf. Das Schwingungsverhalten mindestens eines der Oszillatoren 79, 80 ist durch eine von dem Näherungsschalter 67 erfaßbare Kapazitätsänderung veränderbar. Bei einer bestimmten Schwingungsdifferenz der Oszillatoren 79, 80 wird ein die Ausgabe auslösendes Signal erzeugt. Langfristige Kapazitätsänderungen, also solche, die länger als der Auslösevorgang andauern und von dem kapazitiven Näherungsschalter 67 erfaßt werden, werden in ihrer Wirkung dadurch eliminiert, daß eine Regeleinrichtung vorgesehen ist, welche eine Nachregelung des Schwingungsverhaltens im Sinne einer Wiederherstellung der Synchronisierung bewirkt. Die Regeleinrichtung weist einen Mischer 81 auf, dem die Oszillatorausgangssignale mit ungleicher Spannung zugeleitet werden.

ACTORUM AG

Durch Gleichspannung mittels eines kapazitiven Näherungsschalters betätigbare Ausgabevorrichtung

Die Erfindung betrifft eine durch Gleichspannung
mittels eines kapazitiven Näherungsschalters betätigbare Ausgabevorrichtung für flüssige oder
pastöse Güter, wie Desinfektions- und Putzmittel,
Seifen und Salben, bei der der Näherungsschalter
eine Sensorschaltung mit zwei in Ruhestellung im
wesentlichen synchron schwingenden Oszillatoren aufweist, und das Schwingungsverhalten mindestens eines
der Oszillatoren durch eine von dem Näherungsschalter erfaßbare Kapazitätsänderung veränderbar
ist und bei einer bestimmten Schwingungsdifferenz
der Oszillatoren ein die Ausgabe auslösendes Signal
erzeugt wird.

Die bisher üblichen Ausgabevorrichtungen sind im
allgemeinen handbetätigbar, wie beispielsweise aus
der DE-A 30 36 523 ersichtlich. Diese handbetätigbaren Vorrichtungen sind jedoch dort nicht einsetzbar, wo erhöhte hygienische Anforderungen gestellt
werden. Insbesondere gilt dies für die Seifenspender

-2-

in lebensmittelverarbeitenden Industriebetrieben, wie Molkereien und Metzgereien, in höherem Maße aber für Desinfektionsmittelspender und Seifenspender in Krankenhäusern und Arztpraxen. Hier muß die absolute Gewähr dafür gegeben sein, daß keine Keime auf die Hände des Benutzers, also im allgemeinen des Arztes, speziell des Chirurgen, übertragen werden können. Daraus ergibt sich die Forderung, daß der Spender selbsttätig arbeitet, also ohne Handberührung eine bestimmte Menge seines Inhaltes ausgibt.

Aus der DE-A 26 44 151 ist ein Seifenspender mit Annäherungsschalter bekannt, der diese Forderungen erfüllt, d. h., daß bei Annäherung eines Gegenstandes, beispielsweise der Hand an den Schalter, ein Motor eingeschaltet wird, der eine bestimmte Menge Seife aus dem Behälter auspumpt. Der Motor wird dabei von einer Schaltvorrichtung gesteuert, die auf schnelle Bewegungen in einem elektrischen oder akustischen Feld reagiert, nicht jedoch auf langsame Bewegungen. Die Schaltvorrichtung enthält ferner Zeitglieder, mit denen die Abgabemenge und die Mindestpausenlänge zwischen den einzelnen Seifenabgaben eingestellt werden können.

Bei diesem Aggregat handelt es sich um eine sehr aufwendige Vorrichtung, die aufgrund des eingebauten Motors über das Netz betrieben werden muß, was in Feuchträumen und bei der Ausgabe von Flüssigkeiten nicht unproblematisch ist. In vielen Fällen wird man auch versuchen, einen vorhandenen handbetätigten Spender durch einen automatischen Spender zu er-

-3-

setzen und muß dafür zum vorgesehenen Platz des Spenders nun eine neue elektrische Installation verlegen, was einen zusätzlichen Aufwand bedeutet. Ein wirtschaftlicher Betrieb eines Elektromotors mittels eingebauter Batterien ist auf der anderen Seite nicht möglich, da diese aufgrund der Belastung viel zu schnell verbraucht werden.

Der größte Nachteil des Gerätes liegt jedoch in der Störanfälligkeit der Schaltung. Akustische Felder werden sehr leicht durch Schwingungen beeinflußt, die von Maschinen herrühren, die in der Nachbarschaft aufgestellt sind. Elektrische Felder werden durch Einschaltströme bzw. durch die beim Ein- oder Ausschalten der Maschinen auftretenden Spannungsänderungen beeinflußt, d. h., daß der Spender, ohne daß dieses von einem Benutzer gefordert wurde, aufgrund von Spannungsstößen oder dergleichen Seife ausgibt und sich so, ohne Bedarf, automatisch allein entleert.

Die DE-A 32 31 806 ging deshalb davon aus, eine Sensorschaltung mit zwei synchron schwingenden Oszillatoren auszuführen, von denen einer als Festoszillator und der andere als von außen beeinflußbarer Oszillator ausgeführt ist, einen Trimmer zum Abgleich der Schaltung einzusetzen und die Ansprechentfernung des Näherungsschalters einstellbar zu machen.

Obwohl sich durch diesen Vorschlag die bisher erkannten Problem ohne weiteres gut lösen ließen, er-

-4-

gab sich bei der Montage der Spender immer die Schwierigkeit, daß die Ansprechentfernung jeweils neu eingestellt werden mußte, da die Spender in unterschiedlichen Höhen oberhalb von Waschbecken oder dergleichen angebracht wurden. Ferner stellte sich heraus, daß, insbesondere dann, wenn die Spender sehr dicht oberhalb der Waschbecken angebracht wurden, diese von unten mit Seife sowie Seifenschaum und Schmutz durch Unachtsamkeit in Berührung kamen und sich dadurch die Kapazitäten änderten, was zum Blockieren des Spenders führte. Das Anordnen einer Metallplatte unter dem Spender oder einer elektrisch leitfähigen Schicht in Form eines leitfähigen Lackes erwies sich durch den Einsatz von Reinigungsmitteln für die Reinigung des Behälters als unwirksam, da ein Teil dieser Reinigungsmittel Wachse enthält, die ein Dielektrikum bildeten und damit die leitfähige Schicht in einen Kondensator umfunktionieren. Dadurch wird die Schaltung blockiert, d. h. nach einer einmaligen Ausgabe ist der Spender funktionsunfähig und muß erst mit neutralen Reinigungsmitteln gesäubert werden.

Die DE-A 25 38 531 beschreibt eine Sensorschaltung, die zwei Oszillatoren aufweist, wobei einer der Oszillatoren hochkonstant -gesteuert über Quarz - ausgeführt ist. Nachgeschaltet ist ein spulenloses Bandfilter, dessen Resonanzfrequenz absolut mit dem steuernden Oszillator übereinstimmen muß. Der durch den Einsatz eines Quarzes und eines Operationsverstärkers für das spulenlose Bandfilter bedingte er-

-5-

hebliche Aufwand ist nicht für Massenteile, wie sie Seifenspender usw. darstellen, geeignet. Die Schaltung wirkt als Frequenzdiskriminator, der je nachdem, ob die langfristige Kapazitätsänderung erfolgt, oder rückgängig gemacht wird, ein Signal unterschiedlicher Polarität abgibt. Ersetzt man bei einer solchen Schaltung den Frequenzdiskriminator durch einen Mischer, dem die Ausgangssignale der Oszillatoren zugeführt werden, so hat dieses zur Folge, daß sowohl bei Einsetzen als auch bei Aufhören einer langfristigen Kapazitätsänderung beide Änderungen zu einem Ausgangssignal in gleicher Richtung führen, d. h., daß bei Aufhören der langfristigen Kapazitätsänderung das Ausgangssignal sich in der gleichen Richtung vergrößert, eine "Wegnahme der Störung" hat damit signalmäßig zur Folge, daß sich die Störung noch vergrößert.

Aufgabe der vorliegenden Erfindung ist es, die vorerwähnten Nachteile bekannter Ausgabevorrichtungen zu beseitigen, d. h. einen Spender zu schaffen, der in beliebiger Höhe über irgendwelchen Gegenständen, beispielsweise Waschbecken, angebracht werden kann, ohne daß dazu jeweils eine neue Justierung erforderlich ist. Ferner soll der Spender unempfindlich gegen Verschmutzen des unteren Spenderbereiches, in dem die Sensorplatte angeordnet ist, sein und als Massenteil ohne aufwendige Elektronikelemente preisgünstig gefertigt werden können.

Diese Aufgabe wird bei einer Ausgabevorrichtung gemäß Oberbegriff dadurch gelöst, daß eine Regelvor-

-6-

richtung vorgesehen ist, bei der die Oszillatorausgangssignale den Mischer mit ungleicher Spannung beaufschlagen. Die ungleiche Spannung wird dabei gemäß bevorzugten Ausgestaltungen der Erfindung durch Vorschalten ungleicher Widerstände vor den Mischer erreicht.

Unter Widerstand im Sinne der vorliegenden Anmeldung sind dabei Ohmsche Widerstände, kapazitive Widerstände und induktive Widerstände zu verstehen. Selbstverständlich können diese Widerstandsarten auch untereinander kombiniert werden. Überraschenderweise hat sich dabei ergeben, daß durch ungleiche Speisung des Mischers die Regeleinrichtung so beeinflußt wird, daß nach Beendigung einer langfristigen Kapazitätsänderung -Störung - eine Nachregelung im Sinne einer Gegenregelung -, bezogen auf den vorherigen Zustand - erfolgt.

Eine zweckmäßige Ausgestaltung der Erfindung sieht vor, daß das Ausgangssignal eines der Oszillatoren durch eine langfristige Kapazitätsänderung und das Ausgangssignal des anderen Oszillators durch eine kurzfristige Kapazitätsänderung beeinflußbar ist.

Unter langfristiger Kapazitätsänderung ist dabei eine Kapazitätsänderung für einen längeren Zeitraum zu verstehen als der Zeitraum, der den Schaltvorgang auslöst. Größenordnungsgemäß kann gesagt werden, daß das die Ausgabe auslösende Signal bereits aufgrund einer "kurzfristigen" Kapazitätsänderung in einer Größenordnung von Zehntelsekunden ausgelöst wird,

-7-

während langfristige Kapazitätsänderungen größenordnungsgemäß im Sekundenbereich und darüber liegen. Eine "langfristige" Kapazitätsänderung, die von dem Näherungsschalter erfaßt wird und eine Funktionsstörung zur Folge haben kann, kann beispielsweise durch die Montage der Ausgabevorrichtung oberhalb eines Waschbeckens in zu geringem Abstand hervorgerufen werden, oder aber auch durch das Auflegen beispielsweise einer Nagelbürste auf das Waschbecken, wobei diese Nagelbürste dann in dem Erfassungsbereich des kapazitiven Näherungsschalters verbleibt. Erfindungsgemäß wird eine Nachregelung des Oszillatorschwingungsverhaltens bei "langfristig" einwirkenden Kapazitätsänderungen vorgenommen, derart, daß die vor dem Einwirken der langfristigen Kapazitätsänderung vorhandenen Zustände vollständig oder im wesentlichen wieder hergestellt werden, so daß die Ausgabevorrichtung nach wie vor auf kurzfristige Kapazitätsänderungen, wie sie sich durch eine unter die Ausgabevorrichtung bewegte Hand ergeben, reagiert, d. h. Seife oder dergleichen auspumpt. Auch bei Wegnehmen des die langfristige Kapazitätsänderung bewirkenden Gegenstandes erfolgt eine Nachregelung, d. h. auch in diesem Falle bleibt der Spender funktionsfähig. Durch die erfindungsgemäße Maßnahme ergibt sich daher eine automatische Anpassung der Ausgabevorrichtung bei der Montage über irgendwelchen Gegenständen, des weiteren dann, wenn zwischen der Ausgabevorrichtung und darunter angeordneten Gegenständen, beispielsweise Waschbecken, noch zusätzliche Gegenstände vorübergehend abgelegt werden. Darüber hinaus erfolgt die Nachregelung aber

-8-

auch, wenn der Spender durch Berührung von unten mit
Seife oder dergleichen verschmutzt wird oder sich
auf dem Spender beispielsweise Wasser niederschlägt,
wie das in Duschräumen der Fall sein kann.

Die Regeleinrichtung kann grundsätzlich in der Weise
arbeiten, daß sie auf das Schwingungsverhalten
beider Oszillatoren im Sinne einer Synchronisierung
einwirkt. Darüber hinaus besteht natürlich auch die
Möglichkeit, das Schwingungsverhalten eines der
beiden Oszillatoren entsprechend nachzuregeln.

Es kann auch vorgesehen sein, daß einer der Oszillatoren als Festoszillator und der andere der
Oszillatoren als durch langfristige und kurzfristige
Kapazitätsänderungen beeinflußbarer Oszillator ausgebildet ist.

Nach einem weiteren Merkmal der Erfindung ist vorgesehen, daß die Regeleinrichtung ein Zeitglied aufweist. Mittels dieses Zeitgliedes wird zwischen
kurzfristiger und langfristiger Kapazitätsänderung
unterschieden und die Nachregelung im Sinne einer
Wiederherstellung der Sychronisierung der Oszillatoren erst dann bewirkt, wenn die von dem
Näherungsschalter erfaßte Kapazitätsänderung länger
als der für den üblichen Auslösevorgang erforderliche Zeitraum andauert. Dadurch wird verhindert,
daß bereits bei "normalen" Auslösevorgängen eine
Nachregelung einsetzt.

Entsprechend einer vorteilhaften Ausgestaltung der

-9-

Erfindung ist vorgesehen, daß die Regeleinrichtung eine als Kapazitätsdiode arbeitende Diode aufweist. Bei derartigen Kapazitätsdioden wird bekanntlich durch Erhöhung der in Sperrichtung gepolten Spannung die Kapazität herabgesetzt. Da für die erfindungsgemäße Regeleinrichtung nur ein eingeschränkter Regelbereich erforderlich ist, können neben den eigentlichen Kapazitätsdioden für den vorliegenden Fall auch preiswertere Flächendioden eingesetzt werden, welche in dem in Frage kommenden Bereich in ihrer Kapazität spannungsabhängig sind.

Es kann aber auch vorgesehen sein, daß die als Kapazitätsdiode arbeitende Diode parallel zu dem nicht durch kurzfristige Kapazitätsänderungen beeinflußbaren Oszillator liegt und eine Nachregelung dieses Oszillators bewirkt. Zur Wiederherstellung der Synchronisierung wird in diesem Falle "abwärts" geregelt, d. h., wenn an der Sensorelektrode des Näherungsschalters die Kapazität größer wird, dann muß die Kapazität des nicht durch kurzfristige Kapazitätsänderungen beeinflußbaren Festoszillators im Sinne einer Vergrößerung nachgeregelt werden. Es hat sich gezeigt, daß die letztgenannte Lösung in der Praxis vorteilhafter ist.

In weiterer Ausgestaltung der Erfindung kann vorgesehen sein, daß dem Ladekondensator des Zeitgliedes eine Entladediode zugeordnet ist, d. h., sie ist parallel zum Ladewiderstand geschaltet. Diese Entladediode ermöglicht eine schnelle Entladung, wenn die Störquelle, also die langfristige Kapazitäts-

-10-

änderung, wegfällt. Ohne den Einsatz dieser Entladediode würde die Entladezeit und damit die Zeit, während derer die Ausgabevorrichtung nicht betätigt werden kann, relativ lange dauern. Diese Zeit wird durch Einsatz der Entladediode verkürzt.

In bevorzugter Ausgestaltung der Erfindung kann weiterhin vorgesehen sein, daß dem Mischer ein Verstärkertransistor nachgeschaltet ist. Das Verhältnis des Emitterwiderstandes zu den Kollektorwiderständen des Verstärkungstransistors ist zweckmäßigerweise so, daß die Gleichstromverstärkung um den Wert 1 oder knapp unterhalb des Wertes 1 liegt. Darüber hinaus liegt zweckmäßigerweise in dem Emitterkreis des Verstärkungstransistors ein Kondensator, während zwischen der Basis des Verstärkertransistors und einer Diode sowie dem Ausgang eines dem Kollektor des Verstärkertransistors nachgeschalteten NAND-Schmitt-Trigger ein Kondensator liegt. Da dem Mischer, auf den die Ausgangssignale der Oszillatoren gegeben werden, sowohl die Steuerspannung als auch die Regelspannung entnommen wird, ist es zweckmäßig, den Verstärkertransistor vorzusehen, damit die anstehende Spannung sowohl für die Regelung als auch die Steuerung ausreichend ist. Darüber hinaus wird durch diese Maßnahme die Ansprechempfindlichkeit des Näherungsschalters vergrößert (größenordnungsmäßig verdoppelt). Ein weiterer Vorteil dieser Maßnahme besteht in folgendem:

Die Schaltschwelle des das Ausgabesignal bewirkenden NAND-Schmitt-Triggers sollte nicht durch kleinere

-11-

Störungen überschritten werden. Derartige kleinere Störungen können beispielsweise dann auftreten, wenn die Ausgabevorrichtung über ein Netzanschlußgerät betrieben wird. Der in dem Emitterkreis des Verstärkertransistors parallel zu einem Widerstand liegende Kondensator läßt einen ausreichend langen Impuls durch. Dadurch wird die Stromverstärkung des Transistors groß, weil infolge des durch den Impuls leitend gewordenen Kondensator dessen Emitterwiderstand klein wurde. Somit werden Änderungen am Gleichstromniveau durch den Verstärkungstransistor praktisch nicht übertragen, sondern lediglich Auslöseimpulse. Dies trägt zur Betriebssicherheit der Auslösevorrichtung bei.

Die Schaltung des Kondensators zwischen der Basis des Verstärkertransistors und dem Ausgang des NAND-Schmitt-Triggers bewirkt folgendes:

Wenn der Verstärkungstransistor den erwähnten Auslöseimpuls durchgelassen hat, dann soll der NAND-Schmitt-Trigger nicht länger beeinflußt werden. Andererseits hat aber der in dem Emitterkreis des Verstärkungstransistors liegende Kondensator noch Ladung. Dies könnte bewirken, daß der Verstärkungstransistor länger offen bleibt, was einen Stromverbrauch und damit eine unerwünschte Belastung der Spannungsquelle zur Folge hätte. Durch den erwähnten Kondensator wird der Ausgangsimpuls des NAND-Schmitt-Triggers der Basis des Verstärkertransistors zugeleitet, wodurch der Verstärkungstransistor schlagartig undurchlässig wird.

-12-

Für den Fall, daß die als Kapazitätsdiode arbeitende Diode parallel zu dem nicht durch kurzfristige Kapazitätsänderungen beeinflußbaren Festoszillator liegt, kann in weiterer Ausgestaltung der Erfindung vorgesehen sein, daß dem auf kurzfristige Kapazitätsänderungen ansprechenden Oszillator eine weitere als Kapazitätsdiode arbeitende Diode zugeordnet ist. Damit kann eine Nachregelung beispielsweise von Spannungs- und Temperaturschwankungen erfolgen. Mit Auslösen des Spenders sinkt die Betriebsspannung an einem der vier NAND-Schmitt-Trigger. Damit sinkt sie auch an der weiteren Kapazitätsdiode, was eine Vergrößerung der Kapazität an dieser Diode zur Folge hat, d. h. es ergibt sich der gleiche Effekt wie beim Betätigen des Spenders. Um das zu verhindern, sieht eine weitere Ausgestaltung der Erfindung vor, daß in dem Emitterkreis des Verstärkertransistors ein Kondensator liegt und ein Impuls am Ausgang des NAND-Schmitt-Triggers über einen Kondensator der Basis des Verstärkungstransistors zuführbar ist. Dadurch wird di Spannung an der Kapazitätsdiode so lange gehalten, bis die Betriebsspannung wieder ihren vollen Wert erreicht.

Werden die elektronischen Bauteile für die Energieversorgung und ein in der Auslöseeinrichtung vorgesehener Elektromagnet in einem separaten, von der Ausgabevorrichtung trennbaren Einschub angeordnet, ergibt sich die Schwierigkeit, daß die Kapazität der Sensorplatte des Näherungsschalters von den übrigen elektronischen Bauteilen gelöst wird, d. h., wenn

-13-

der Einschub gezogen wird, erfolgt ein Kapazitätsabfall, wodurch sich die gleiche Steuerspannung ergibt, die auch bei einem Kapazitätsanstieg auftritt.
Damit ist die Regelbarkeit gestört. Wird jedoch bei
dem Ziehen des Einschubs ein Ersatzkondensator eingeschaltet, so erfolgt kein Kapazitätsabfall bzw.
ein Kapazitätsabfall in ganz geringen Ausmaßen. Mit
der Einbringung des Einschubs wird der Ersatzkondensator wieder ausgeschaltet, so daß sich praktisch
ohne Kapazitätsänderung der Spender wieder im gebrauchsfertigen Zustand befindet. Der Einschub ist
dabei über einen Abschirmkontakt und dem Sensorkontakt mit der Sensorplatte verbunden.

Die Sensorschaltung enthält vorteilhaft vier
NAND-Schmitt-Trigger, wobei zwei als Oszillatoren,
der dritte als Mischer und der vierte als Schwellwertschalter geschaltet ist. Dem Verstärkertransistor ist am Basiseingang eine Diode bzw. eine Zenerdiode zugeordnet.

Die Erfindung wird nachstehend anhand der
Zeichnungen näher erläutert. Es zeigen:

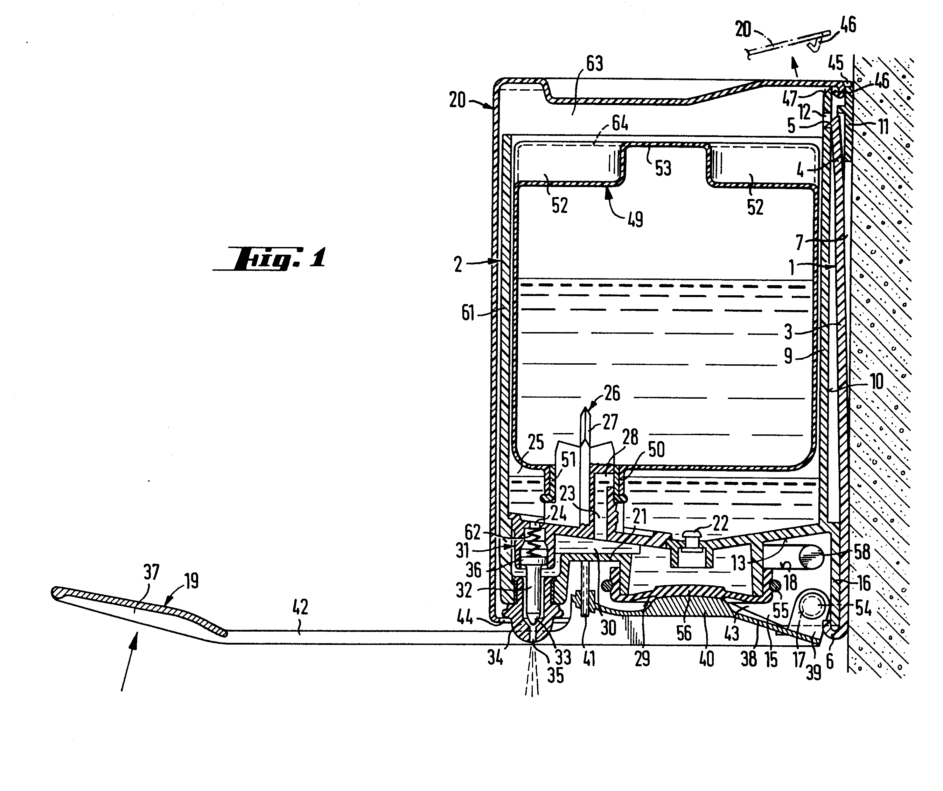

Fig. 1 einen handelsüblichen Ausgabebehälter im
Schnitt,

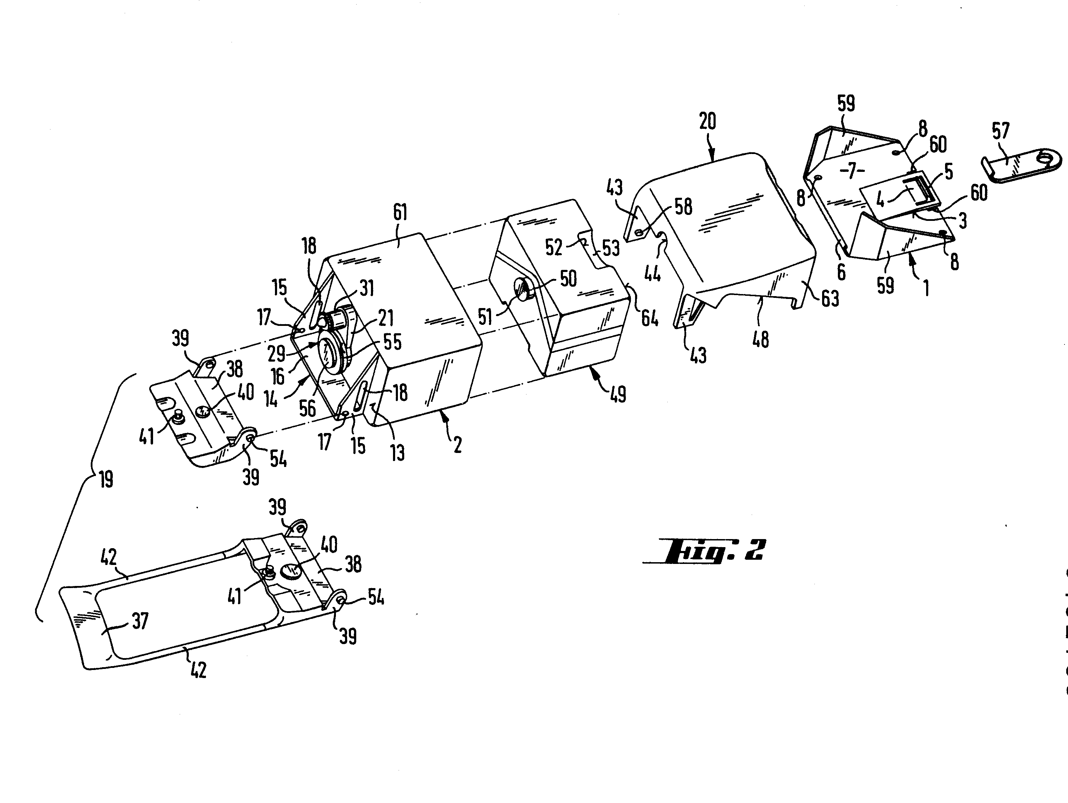

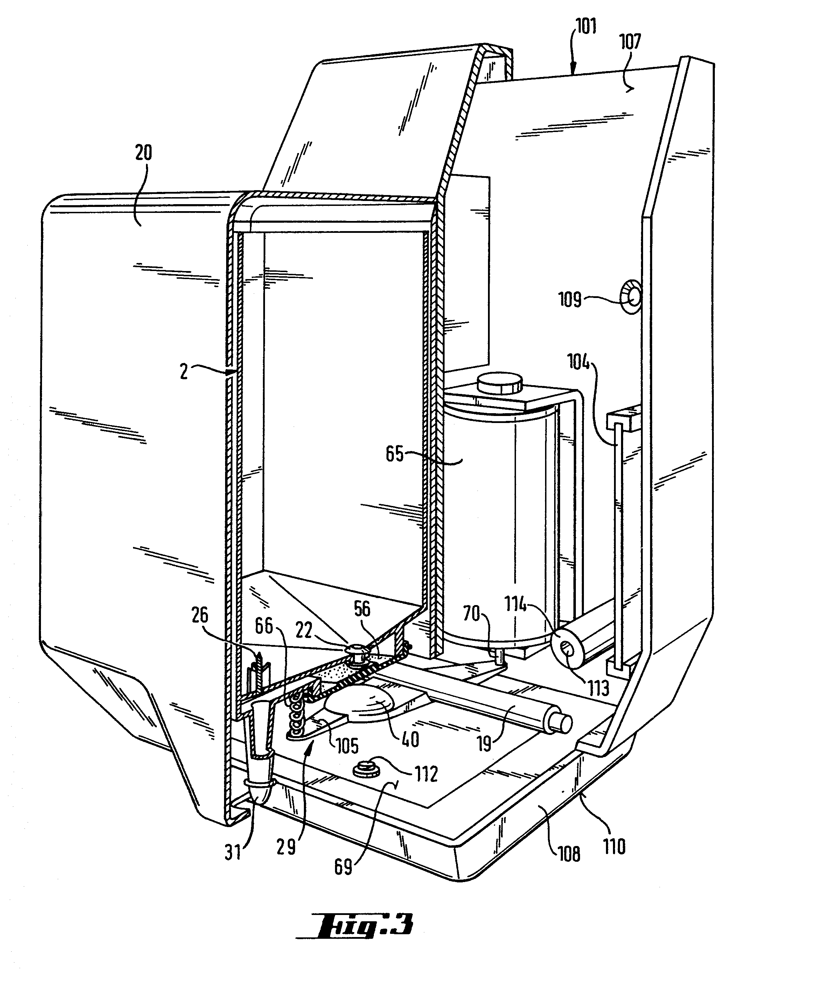

Fig. 2 diesen Ausgabebehälter als Explosionsschaubild, wobei die Einzelteile perspektivisch
dargestellt sind,

Fig. 3 den erfindungsgemäßen Ausgabebehälter perspektivisch im Teilschnitt,

Fig. 4 als Explosionsschaubild Einzelteile des Aus-

-14-

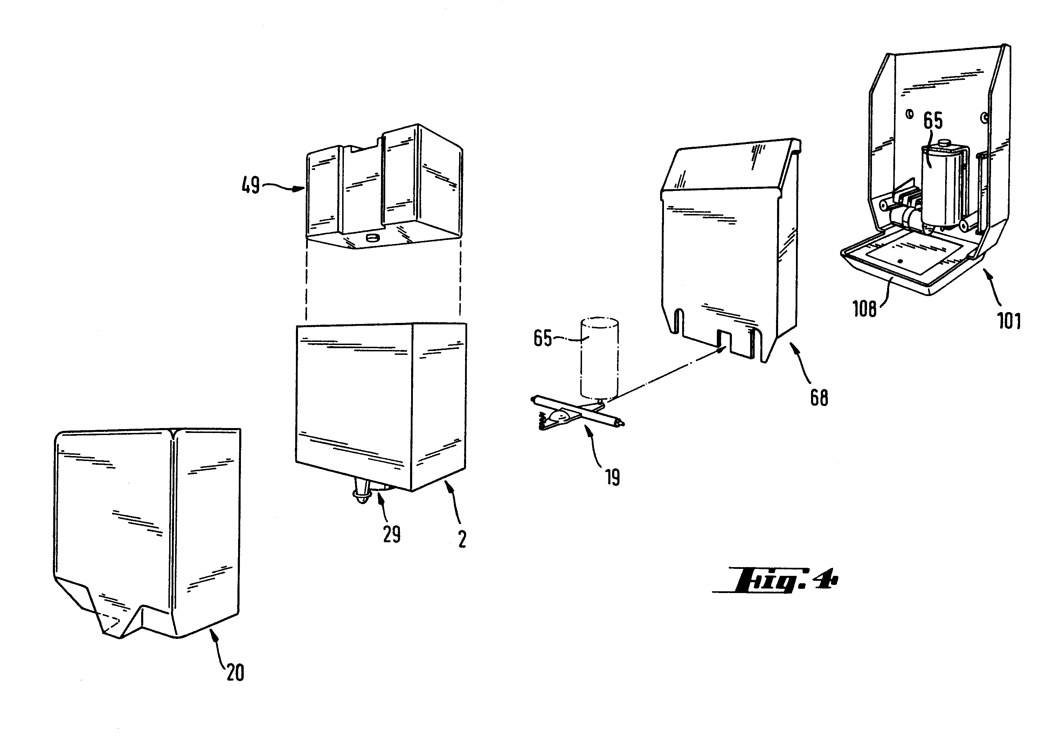

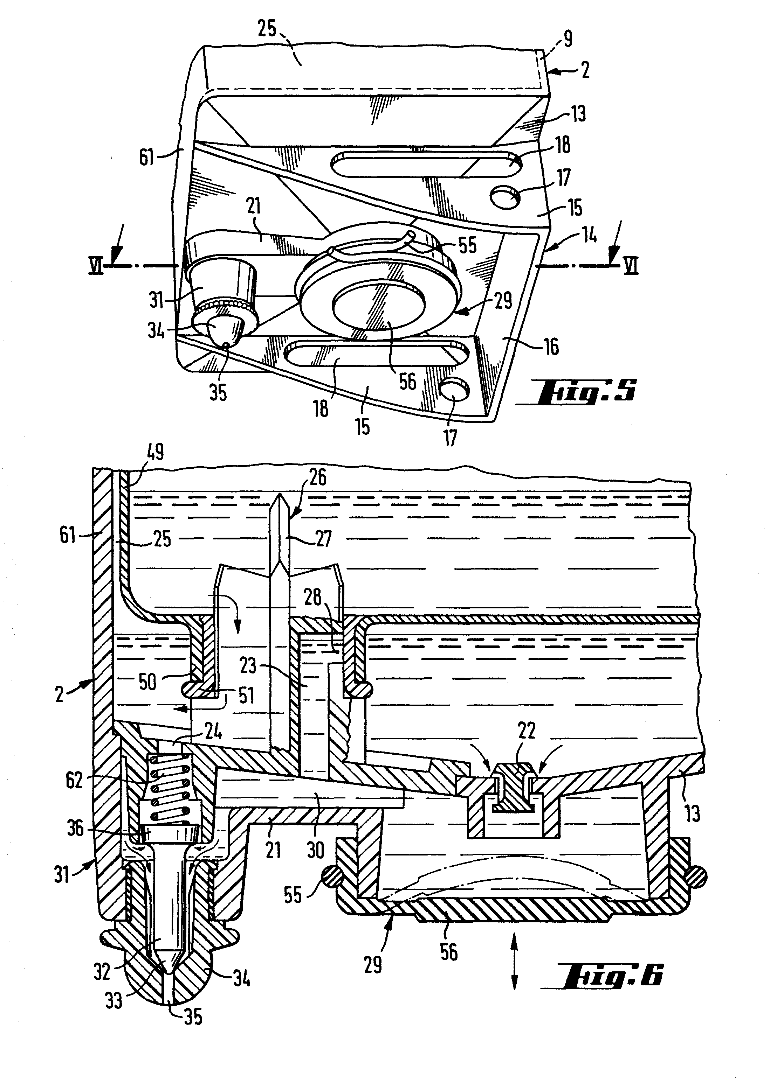

gabebehälters gemäß Fig. 3,

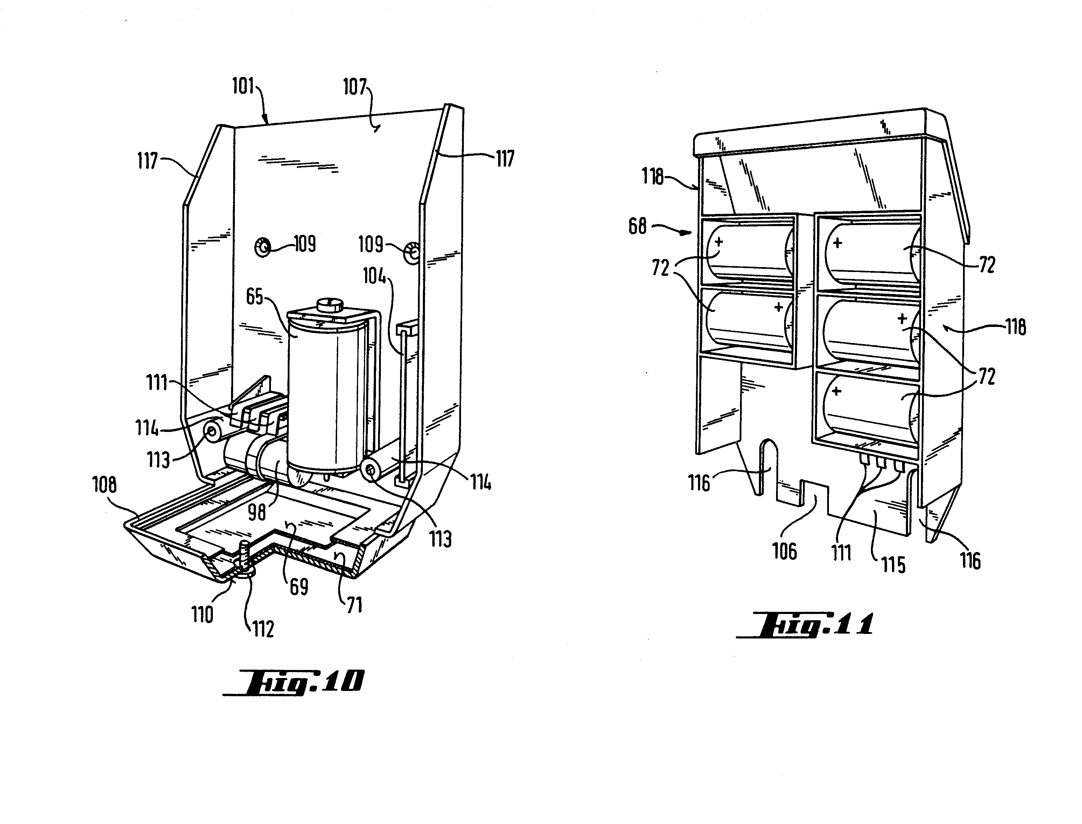

Fig. 5 den Pumpenbereich des Ausgabebehälters in perspektivischer Darstellung,

Fig. 6 als Detail einen Schnitt des Ausgabebehälters gemäß der Linie VI-VI in Fig. 5,

Fig. 7 das Elektronikgehäuse in perspektivischer Darstellung von der Rückseite,

Fig. 8 das gleiche Gehäuse von der Vorderseite,

Fig. 9 den Einschub mit dem Batterieteil,

Fig. 10 die Innenansicht des Elektronikgehäuses mit Sensorplatte und Abschirmelektrode bei im Gehäuse angeordneten Elektromagneten,

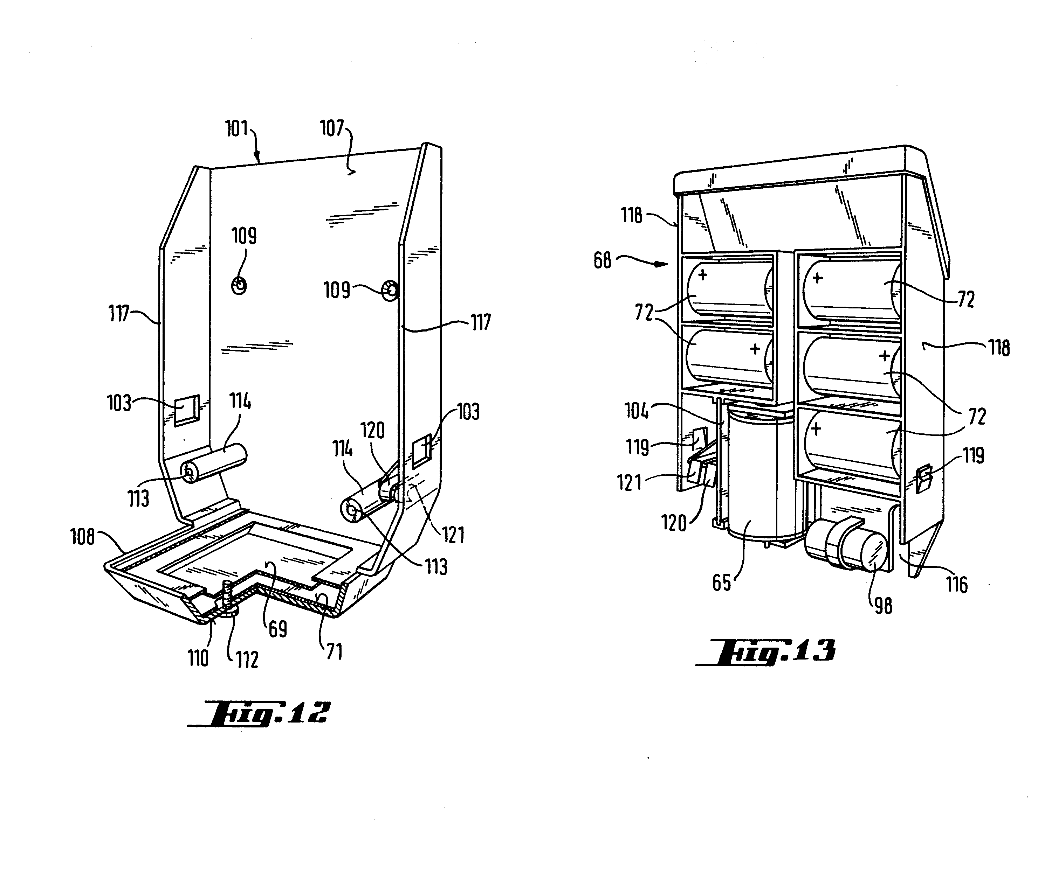

Fig. 11 den zugehörigen Einschub,

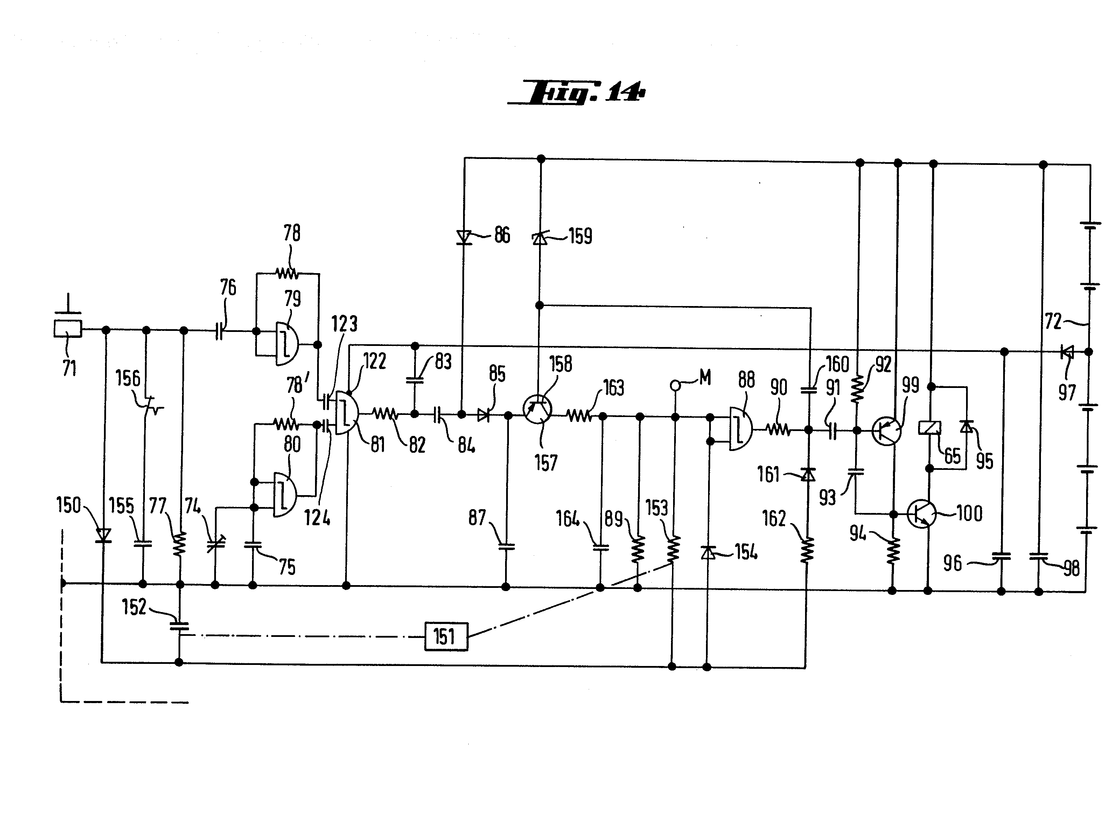

Fig. 12 ein Elektronikgehäuse ohne Einbauten mit Rastenfenster,

Fig. 13 den zugehörigen Einschub mit Rasten, eingebautem Elektromagnet und Platine,

Fig. 14,

15

und 16 je eine Ausführungsform des Schaltbildes der Platine.

Die Wandbefestigung 1 besteht aus einer ebenen Platte, die die Rückwand 7 bildet und Bohrungen 8 aufnimmt, die zum Verschrauben der Wandbefestigung an eine Raumwand dienen. Die Bohrungen 8 sind ausgesenkt, so daß Senkschrauben eingesetzt werden können. Die Rückwand 7 wird rechts und links von Seitenwänden 59 begrenzt, die eine dreieckige Form aufweisen und im unteren Bereich abgewinkelt sind. Zwischen den abgewinkelten Enden der Seitenwände 59 erstreckt sich eine rinnenförmige Halterung 6, die

-15-

direkt an der Rückwand 7 angebracht ist und ebenso wie die Führung 3, die Feder 4 und der hakenförmige Ansatz 5 zur Aufnahme bzw. Befestigung des Ausgabebehälters 2 dient.

Die Führung 3 weist die Form einer Lasche auf, die um die Wandstärke der Rückwand 7 versetzt nach innen an der Rückwand 7 angeordnet ist. In ihrem oberen Bereich ist sie durch rechts und links angeordnete Freiräume 60 von der Rückwand 7 getrennt, so daß die Brücke 11, in der die Führungsnut 10 des Ausgabebehälters 2 entlang seiner Rückwand 9 endet, die Führung 3 umgreift. Die Feder 4 trägt an ihrem oberen Ende einen hakenförmigen Ansatz 5 und ist integrales Teil der Führung 3. Sie greift beim Einsetzen des Ausgabebehälters 2 in den im Vorderteil der Brücke 11 befindlichen Halteschlitz 12 ein, wodurch der Ausgabebehälter 2 in der Wandbefestigung arretiert ist.

Der Ausgabebehälter 2 weist an seinem Boden 13 ein U-förmiges Profil 14 auf. Der Steg 16 des U-förmigen Profils 14 erstreckt sich parallel zur Behälterrückwand 9 und wird durch die rinnenförmige Halterung 6 der Wandbefestigung 1 aufgenommen. Die rechts und links des Steges 16 angeordneten Schenkel 15 des U-förmigen Profils 14 weisen ein dreieckiges Profil auf, d. h., sie verjüngen sich von der Behälterrückwand 9 zur Behältervorderwand 61 und weisen in der nach unten zeigenden Spitze des Dreiecks je eine Lagerbohrung 17 auf, während sich parallel zum Boden 13 je ein Langloch erstreckt.

Unter dem Boden 13 des Ausgabebehälters 2 ist ein Modul 21 angeordnet, der den Behälterboden 13 teilweise durchdringt und in den Behälterinnenraum 25 hineinragt. Unterhalb des Einlaßventils 22 ist der Modul 21 als Ringansatz ausgebildet und formt hier den Körper der Pumpe 29, d. h. einen rohrförmigen Stutzen, der von der Pumpenmembran 56 abgeschlossen wird. Die Pumpenmembran 56 weist Topfform auf. Ihr mittleres Bodenstück ist verstärkt ausgeführt, der den zylindrischen Teil der Pumpe 29 umgreifende Rand wird durch einen Haltefederring 55 mit dem Modul 21 verbunden.

Von der Pumpe 29 erstreckt sich ein Pumpkanal 30 in Richtung des Auslaßventils 31. Mit diesem Pumpkanal 30 ist ein Entlastungskanal 23 verbunden, der in eine Öffnung 28 mündet, die sich in einem Dorn 27 unterhalb des Messers 26 befindet. Im Betriebszustand des Seifenspenders ist die Öffnung 28 durch den Halsansatz 50 des Vorratsbehälters 49 abgedeckt, so daß bei Betätigung der Pumpe 29 die flüssige Seife nicht in den Behälterinnenraum 25 zurückgedrückt wird, sondern über den Pumpkanal 30 das Auslaßventil 31 erreicht.

Der beim Pumpvorgang auftretende Druck schließt das Einlaßventil 22 und hebt durch Druck auf den Druckflansch 36 des Ventilkörpers 32 diesen gegen die Wirkungsrichtung der Druckfeder 62 an, wodurch die Ventilkörperspitze 33 die Düsenbohrung 35 in der Ventilkappe 34 freigibt, so daß die Seife aus der

0152735

-17-

Düsenbohrung 35 austreten kann. Um zu vermeiden, daß z. B. durch Temperaturänderungen der Druck im Pumpkanal 30 ansteigt und das Ventil leck wird, ist eine Ausgleichsbohrung 24 vorgesehen.

Die Betätigung der Pumpenmembran 56 erfolgt über einen Betätigungshebel 19. Der Betätigungshebel 19 besteht aus einem Griff 37 und einer Abdeckplatte 38, die den gesamten Bodenbereich des Seifenspenders verschließt und so ein Verschmutzen der Pumpe 29 und des Auslaßventils 31 von außen verhindert. Auf der Abdeckplatte 38 ist ein Druckpolster 40 angeordnet, das aus einem zylindrischen Aufsatz mit abgeflachtem kugeligem Ansatz besteht. Dieses Druckpolster 40 greift bei der Bewegung des Griffes 37 an der Pumpenmembran 56 an und drückt diese in den Modul 21 ein, wodurch die dort befindliche Seife über das Auslaßventil 31 ausströmt.

Eine im vorderen Bereich der Abdeckplatte 38 angeordnete Anschlagschraube 41 dient zur Begrenzung der Bewegung des Griffes 37 und damit zur Regulierung der Eindringtiefe des Druckpolsters 40 in die Pumpenmembran 56. Durch diese Regulierung wird die auszugebende Seifenmenge eingestellt. Die Anschlagschraube 41 ist dabei normalerweise als Madenschraube ausgeführt, die selbsthemmend in der Abdeckplatte 38 angeordnet ist.

Die Lagerung des Griffes 37 erfolgt über Gelenkhebel 39, die federnd mit dem Griff 37 verbunden sind. Sie tragen an ihren Enden nach außen gerichtete Achs-

-18-

stummel 54, die in die Lagerbohrungen 17 des
U-förmigen Profils 14 eingreifen.

Bei Einsatz des Seifenspenders in desinfizierten
Räumen ist es erforderlich, daß der Bedienende, beispielsweise ein Chirurg, mit sterilen Händen arbeitet und nicht mit den Händen den Griff 37 des
Seifenspenders berührt. Die Betätigung des Seifenspenders soll mit dem Arm erfolgen, wozu der Betätigungshebel 19 durch Distanzstücke 42 so verlängert wird, daß die Distanzstücke 42 den Griff 37
mit der Abdeckplatte 38 und dem Gelenkhebel 39 verbinden. Die Abdeckhaube 20 ist in ihrem unteren Bereich mit zwei Scharnierarmen 43 versehen, an denen
sich Gelenkzapfen 58 befinden. Diese Gelenkzapfen 58
greifen in die Langlöcher 18 des U-förmigen Profils
14 ein, so daß die Abdeckhaube 20 in Richtung auf
die Wandbefestigung 1 verschoben werden kann, derart, daß die Nase 46, die die Ausnehmung 45 in der
Abdeckhaube 20 begrenzt, hinter die Raste 47 des
Ausgabebehälters 2 einrastet.

Die im Bodenbereich der Abdeckhaube 20 befindliche
Aussparung 44 bildet eine Öffnung für das Auslaßventil 31, durch die die Seife austritt.

Die Sichtfenster 48 befinden sich in den Haubenseitenwänden 63 der Abdeckhaube 20 und werden nur
einseitig von der Haubenseitenwand 63 begrenzt. Die
gegenüberliegende Begrenzung erfolgt durch die Wandbefestigung 1, d. h. deren Seitenwände 59.

Der Vorratsbehälter 49 weist quaderförmige Gestalt auf und besitzt an einer Längsseite einen nach außen ragenden Halsansatz 50, der mit einer Folienkappe 51 abgedeckt ist. Der Vorratsbehälterboden 64 weist zwei gegenüberliegende Vertiefungen 52 auf, die in der Mitte einen Steg 53 freilassen. Dieser Steg 53 dient zum Einsetzen des Vorratsbehälters 49 in den Ausgabebehälter 2, wobei die Vertiefungen 52 gestatten, daß der Steg 53 mit den Fingern ergriffen werden kann.

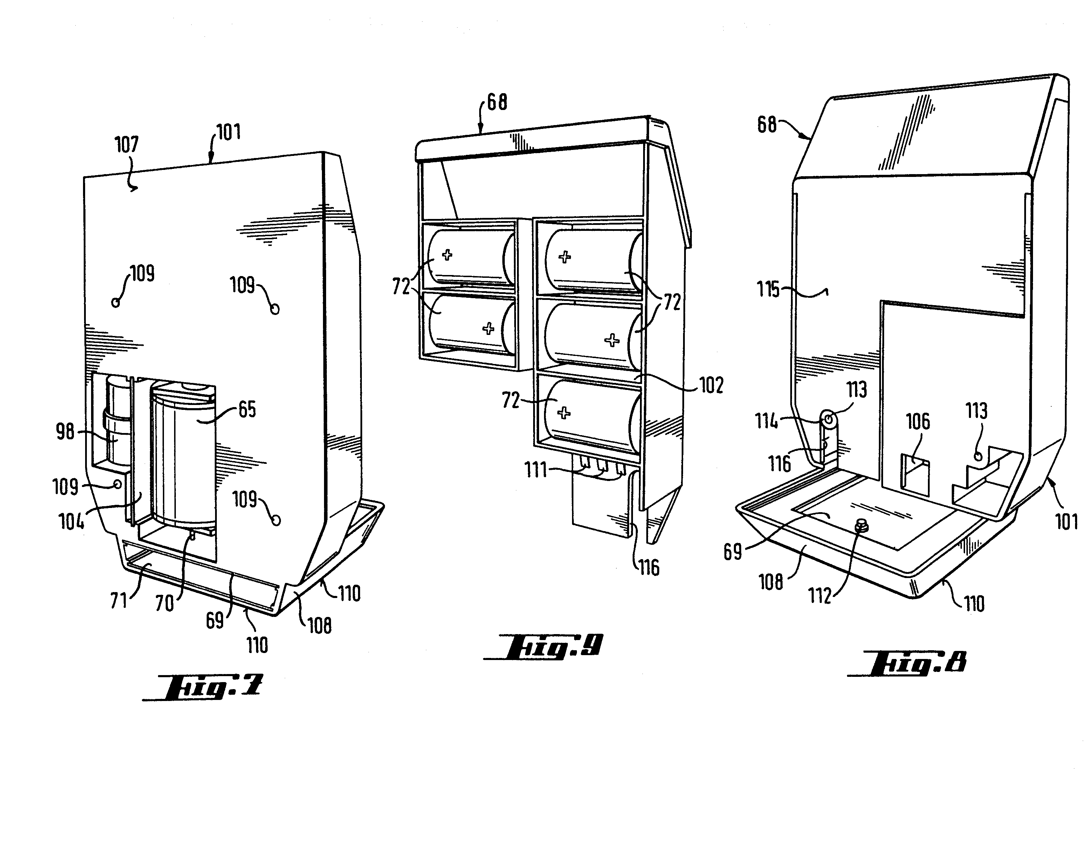

Das Öffnen des Seifenspenders erfolgt mittels eines Hebels 57, der aus einem an einem Ende sichelförmig gebogenen Flachmaterial besteht. Das sichelförmig gebogene Stück des Hebels 57 wird dazu in die Ausnehmung 45 eingelegt und der Hebel 57 dann nach oben bewegt. Der Hebel 57 stützt sich dabei an der Wand ab (bei Fig. 3 am Elektronikgehäuse 101) und hebt die Nase 46 der Abdeckhaube 20 aus einer Raste 47 des Ausgabebehälters 2 hinaus, so daß die Abdeckhaube 20 in dem Langloch 18 durch die Gelenkzapfen 58 geführt, auf den Bedienenden zubewegt und zur Freigabe des Ausgabebehälters 2 abgeklappt werden kann. In den Ausführungsbeispielen nach Fig. 3 bis 13 ist der Mechanismus der Abdeckhaube ähnlich, wurde aber in der Zeichnung nicht weiter dargestellt.

Die Fig. 3 zeigt, wie der gleiche Spender durch Austauschen des Betätigungshebels 19 in einen elektronisch betätigbaren Spender umrüstbar ist. Der Betätigungshebel 19 ist in diesem Falle als Doppelhebel ausgeführt, von denen der eine Arm wie bisher das Druckpolster 40 trägt, das auf die Pumpenmembran 56 einwirkt, wohingegen der zweite Arm durch den Magnetanker 70 des Elektromagneten 65 beaufschlagt wird. Der Elektromagnet 65 ist bei dieser Ausführungsform im rückwärtigen Bereich des Elektronikgehäuses 101 fest installiert, neben ihm ist eine Platine 104 angebracht, die die Elektronikaggregate zur Steuerung des Elektromagneten 65 aufnimmt.

Die Hebelseite des Betätigungshebels 19, die das Druckpolster 40 trägt, weist eine Verlängerung 105 auf, in deren vorderem Bereich eine Rückholfeder 66 angeordnet ist. Diese Rückholfeder 66 hat im wesentlichen die Aufgabe, das Gewicht des Magnetankers 70 auszugleichen und dadurch die Pumpenmembran 56 weitgehend zu entlasten.

Da alle elektrischen Komponenten nach Möglichkeit völlig vom Naßteil des Seifenspenders getrennt sein sollten, sind sie, wie die Fig. 7 und 8 zeigen, gekapselt. In einfachster Form kann das dadurch geschehen, daß das Elektronikgehäuse 101 zur Vorderseite hin geschlossen ist und nur einen Durchbruch 106 aufweist, über dem sich der Elektromagnet 65 befindet und in den der Betätigungshebel 19 eingreift. Bei dieser Ausführungsform ist, wie Fig. 7 zeigt, der Elektromagnet 65 von der Rückseite 107 des Elektronikgehäuses 101 zugänglich, ebenso wie die Platine 104 und der Anschließkondensator 98.

Die Sensorplatte 71 ist am Boden der Tasche 108 des

Elektronikgehäuses 101 angeordnet. Über ihr befindet sich die Abschirmelektrode 69, die die Sensorplatte 71 vor der Beeinflussung durch den Füllstand der Seife im Vorratsbehälter 49 abschirmt. Nicht dargestellte Schrauben werden durch die Befestigungsbohrungen 109 geführt und dienen zur Befestigung des Elektronikgehäuses an einer Wand oder dergleichen.

Die Tasche 108 ist in ihrem unteren Bereich mit einer leitfähigen Schicht 110 versehen, die eine Beeinträchtigung der Seifenausgabe aus der Ausgabevorrichtung durch Verschmutzen der Taschenunterseite verhindert bzw. verringert.

Der Einschub 68, der senkrecht von oben in das Elektronikgehäuse 101 eingeschoben wird, enthält die Spannungsquelle, also die elektrochemischen Elemente 72. In Fig. 9 sind diese elektrochemischen Elemente als Monozellen dargestellt, statt dessen können aber auch wiederaufladbare Akkumulatoren eingesetzt werden. Über die Kontaktfedern 111 wird der Einschub 68 elektrisch mit dem Elektronikgehäuse 101 verbunden, das ebenso, wie Fig. 10 zeigt, Kontaktfedern 111 aufweist. Zwischen den einzelnen Kontaktfedern 111 herrscht unterschiedliche Spannung, da der Elektromagent 65 mit voller Spannung betrieben werden muß, um die erforderliche Leistung zu erbringen, der Näherungsschalter 67 als solcher aber mit einer geringeren Spannung betrieben werden kann, wodurch Strom eingespart wird. Der Näherungsschalter 67 weist dabei die Platine 104, den Anschießkondensator 98 sowie die Sensorplatte 71 auf, die gemäß Fig. 10 im Elektronikgehäuse 101 untergebracht sind.

Eine Einstellschraube 112 aus isolierendem Material ermöglicht durch Verstellen der Höhe der Abschirmelektrode 69 in der Tasche 108 ein Einstellen der Ansprechentfernung, d. h. der Entfernung, bei der der Spender bei Annäherung der Hand unter den Spender, also in dem Bereich der Sensorplatte 71, Seife ausgibt.

Aufnahmebohrungen 113 dienen dem Verschrauben des Ausgabebehälters 2 mit dem Elektronikgehäuse 101. Sie sind in Ansätzen 114 angeordnet, die Teil der Rückseite 107 des Elektronikgehäuses 101 sind.

Gemäß Fig. 7 und Fig. 8 sind die elektrischen Teile dadurch gekapselt, daß sie vom Elektronikgehäuse 101 nach vorn, also zur Seifenspenderseite, umschlossen sind, so daß sie nur von der Wandseite erreicht werden können. Fig. 10 zeigt hier die alternative Lösung, d. h. alle elektrischen Teile sind auf der Rückseite 107 des Elektronikgehäuses 101 angeordnet und somit von vorne offen zugänglich. Die Abdeckung gegenüber dem Seifenspender erfolgt durch den Einschub 68, wie er in Fig. 11 dargestellt ist, und dessen Vorderseite 115 bis auf den Durchbruch 106, durch den der Betätigungshebel 19 am Elektromagneten 65 angreift und die Langlöcher 116 völlig geschlossen ist.

Die Fig. 12 und 13 zeigen eine weitere Paarung von Elektronikgehäuse 101 und Einschub 68, wobei hier

-23-

der Einschub 68 alle die elektrischen bzw. elektronischen Teile aufnimmt, die einer Wartung bedürfen. Das sind zum einen die elektrochemischen Elemente 72, die nachgeladen oder ersetzt werden müssen, zum anderen die Platine 104, die ggf. überprüft werden muß, des weiteren der Elektromagnet 65 und der Anschießkondensator 98. Da der Elektromagnet 65 gegenüber dem Betätigungshebel 19 stets eine feste, sich nicht verändernde Position einnehmen muß, wenn eine gleiche Ausgabemenge durch die Pumpbewegung bewerkstelligt werden soll, ist der Einschub 68 in seiner Lage arretiert. Die Arretierung erfolgt im rechten und linken Flügel 117 des Elektronikgehäuses 101 durch das Einbringen von Rastenfenstern 103 und durch an den Einschubseitenwänden 118 angeordneten federnde Lappen 119, die aus der Einschubseitenwand 118 nach außen heraus federn und so in die Rastenfenster 103 des Elektronikgehäuses 101 eingreifen. Beim Einsetzen des Einschubs 68 in das Elektronikgehäuse 101 werden diese federnden Lappen 119 nach innen gedrückt und treten erst am Rastenfenster 103 wieder nach außen, wo sie den Einschub 68 in der vorgesehenen Position arretieren. Bei dieser, in Fig. 12 dargestellten Ausführungsform, weist das Elektronikgehäuse 101 nur noch im Bereich der Tasche 108 Teile auf, die mit dem Näherungsschalter 67 über den Abschirmkontakt 120 und den Sensorkontakt 121 verbunden sind.

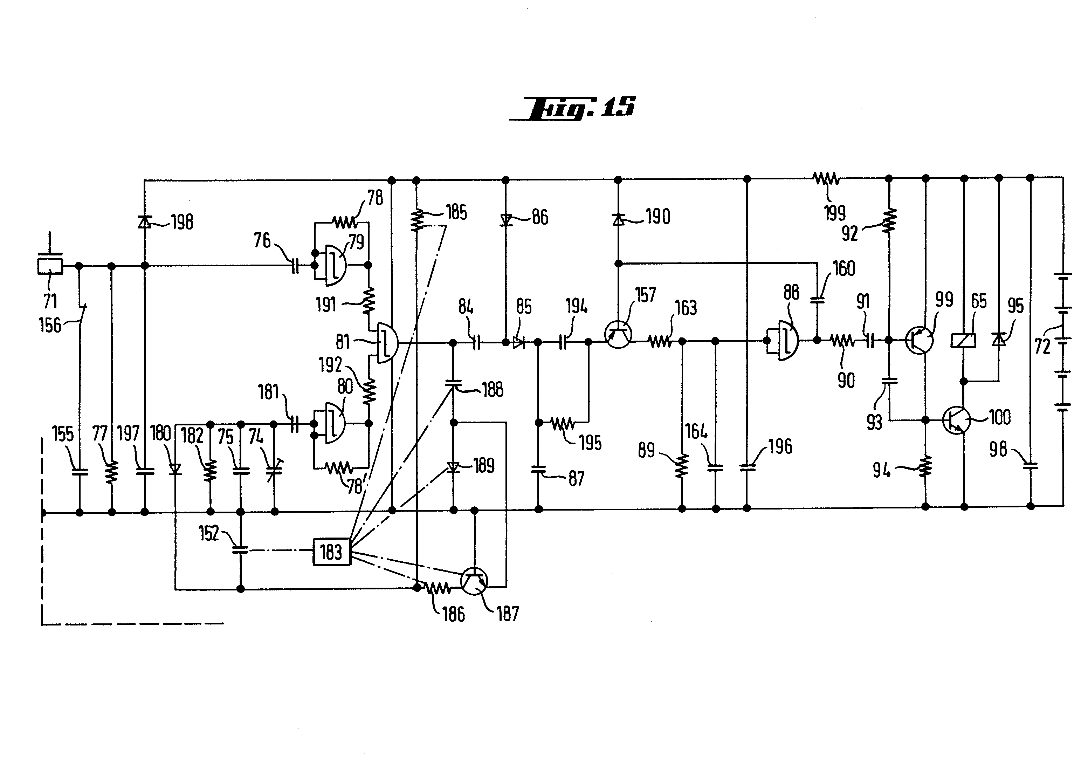

Fig. 14 zeigt den Schaltplan einer Ausführung des Näherungsschalters 67. Die Sensorplatte 71, durch die der gesamte Annäherungsschalter beeinflußt wird,

-24-

ist über einen Trennkondensator 76 mit dem Eingang eines als Oszillator geschalteten NAND-Schmitt-Triggers 79 verbunden. Ein Widerstand 78 dient zur Rückkopplung und ist in Verbindung mit der Kapazität der Sensorplatte 71 und einer Kapazitätsdiode 150 frequenzbestimmend. Ein Widerstand 77 dient zur Speisung der Kapazitätsdiode 150. Bei herausgezogenem Einschub ist die Sensorplatte 71 von dem Annäherungsschalter getrennt. Ein Schalter 156 schaltet in diesem Zustand einen Ersatzkondensator 155 anstelle der Sensorplatte 71 zu.

Ein als Festoszillator schwingender NAND-Schmitt-Trigger 80 ist über einen Widerstand 78' rückgekoppelt. Die Oszillatorfrequenz wird bestimmt durch den Widerstand 78', einen Kondensator 75 und einen Trimmerkondensator 74, wobei der Kondensator 75 den Regelbereich des Trimmerkondensator 74 begrenzt. Ein weiterer NAND-Schmitt-Trigger 81 ist als Mischer geschaltet, dessen beide Eingänge mit den Ausgängen der Oszillatoren 79 und 80 über kapazitive Widerstände 123, 124 verbunden sind. Der kapazitive Widerstand 123 ist dem Ausgang des Oszillators 79, der kapazitive Widerstand 124 dem Ausgang des Oszillators 80 nachgeschaltet. Der Mischer 81 wird dadurch mit unterschiedlicher Spannung beaufschlagt. Schwingen die Oszillatoren 79 und 80 synchron, so ist keine oder nur geringe Spannung am Ausgang des Mischers 81 vorhanden. Weicht der Oszillator 79 durch Annäherung beispielsweise einer Hand an die Sensorplatte 71 ab, so entsteht ein niederfrequentes Ausgangssignal, welches zur Steuerung und Regelung verwendet wird.

Ein Widerstand 82 bildet mit einem Kondensator 83 ein Siebglied zur Abtrennung noch vorhandener Hochfrequenzreste. Ein Trennkondensator 84 trennt das am Ausgang des Mischers 81 vorhandene Gleichspannungspotential ab und leitet das entstandene gleichspannungsfreie Niederfrequenzsignal einer Diode 85 zu, deren positive Ausgangsspannung einen Transistor 157 steuert, während die negative Halbwelle durch eine Diode 86 kurzgeschlossen wird. Ein Kondensator 87 dient als Ladekondensator. Die Basis 158 des als PNP-Transistors ausgebildeten Transistors 157 ist über eine Zenerdiode 159 mit der positiven Betriebsspannung einer Spannungsquelle 72 verbunden.

Ein Ladekondensator 87 ist parallel zur Kurzschlußdiode 86 geschaltet und vor dem NAND-Schmitt-Trigger 88 angeordnet, dem der Ladewiderstand 90 und der Differenzierkondensator 91 nachgeschaltet sind. Der Differenzierkondensator 91 ist mit dem Entladewiderstand 92 und dem Rückkoppelungskondensator 93 verbunden, der über den Treibertransistor 99 und den Leistungstransistor 100 den Elektromagneten 65 beaufschlagt. Parallel zu diesem ist die Diode 95 zum Kurzschließen von Spannungsspitzen beim Abschalten geschaltet. Der Anschließkondensator 98 ist parallel zum elektrochemischen Element 72 angeordnet, so daß der Elektromagnet 65 stets mit der vollen Spannung versorgt wird, wenn der Leistungstransistor 100 anspricht. Die Basis des Leistungstransistors 100 und der Treibertransistor 99 sind dabei über einen

0152735

-26-

Emitterwiderstand 94 mit Masse verbunden.

Der Kollektor des Transistors 157 ist über einen
Widerstand 163 und einen Widerstand 189 mit der
negativen Betriebsspannung verbunden. Der Widerstand
163 dient als Schutzwiderstand, der verhindert, daß
bei Kurzschluß eines Meßpunktes M gegen Masse der
Transistor zerstört wird. Ein Kondensator 164 ist
dem Eingang des NAND-Schmitt-Triggers 88 zugeordnet
und verhindert, daß dieser durch Eindringen steiler
Fremdimpulse ausgelöst wird. Ein Widerstand 153 ist
Bestandteil eines Zeitgliedes 151, das außerdem
einen Ladekondensator 152 enthält. Ist kein oder nur
ein kleines positives Ausgangssignal am Transistor
157 enthalten, so ist auch der Ladekondensator 152
nicht oder nur wenig aufgeladen. Die Kapazitätsdiode
150 liegt mit ihrer Kathode an dem Kondensator 152
und hat in diesem Zustand maximale Kapazität.

Eine kurzzeitige Störung, wie beispielsweise eine
Annäherung einer Hand an die Sensorplatte 170, erzeugt am Ausgang des Transistors 157 ein kurzzeitiges Signal. Die Zeitkonstante des Zeitgliedes
151, bestimmt durch den Widerstand 153 und den Ladekondensator 152, ist so groß eingestellt, daß die
Spannung am Ladekondensator 152 durch eine kurzfristige Störung an der Sensorplatte 71 nur wenig
angehoben wird. Damit tritt die Kapazitätsdiode 150
nur minimal in Funktion. Erfolgt eine längerfristige
Störung an der Sensorplatte 71, wie beispielsweise
eine Verschmutzung oder zu nahe Montage über einem
Waschbecken, entsteht am Kollektor des Transistors 157 eine bleibende Ausgangsspannung. Der Ladekondensator 152 kann sich nun über den Widerstand 153 kräftig aufladen, und die Kapazität der Kapazitätsdiode 150 wird solange kleiner, bis der Oszillator 79 sich dem Oszillator 80 angepaßt hat. Damit verschwindet das Niederfrequenzausgangssignal am Mischer 81 und somit auch das Signal am Kollektor des Transistors 157. Die Sensorplatte 71 ist damit wieder auslösebereit.

Um nach Wegfall der Störung den Ladekondensator 152 schnell zu entladen, ist eine Diode 154 vorgesehen. Damit der Transistor 157 nach einem Auslösevorgang schlagartig gesperrt wird, ist am Ausgang des NAND -Schmitt-Triggers 88 ein Kondensator 160 angeordnet, der die steile Impulsflanke des NAND-Schmitt -Triggers nach Verzögerung durch einen Widerstand 90 auf die Basis des Transistors 157 überträgt. Die Zenerdiode 159 sorgt dafür, daß der Impuls nicht nach dem positiven Pol der Spannungsquelle abfließen kann. Eine am Ausgang des NAND-Schmitt-Triggers 88 angeschlossene Diode 161 und ein Widerstand 162 dienen zur Begrenzung der Regelspannung am Ladekondensator 152 während einer Dauerstörung, so daß Regelspielraum an der Kapazitätsdiode vorhanden bleibt und damit bei einem Verschwinden einer Dauerstörung eine Spannungsänderung an der Kapazitätsdiode in der richtigen Richtung erfolgt.

Der Widerstand 90 bildet mit einem Kondensator 91 ein Differenzierglied, das nur das Steuersignal

0152735

-28-

weiterleitet. Gleichspannungsänderungen an dem NAND-Schmitt-Trigger durch Störungen oder Defekte in der Schaltung gegenüber dem Schaltverstärker, bestehend aus Transistoren 99 und 100, werden gesperrt. Ein Widerstand 92 dient zur Entladung des Differenziergliedes und ist gleichzeitig Basiswiderstand des Transistors 99. Der Kondensator 93 dient als Rückkopplungskondensator und bewirkt ein schnelles Durchschalten des Schaltverstärkers.

Die Stromversorgung des Annäherungsschalters erfolgt durch fünf Monozellen zu jeweils 1,5 V. Die Versorgung der vier NAND-Schmitt-Trigger, die in einem IC integriert sind, erfolgt über eine Anzapfung bei 4,5 V.

Um Rückwirkungen während des Schaltvorganges zu vermeiden, wird der aufgeladene Kondensator 96 über eine Diode 97 von der Batterie 72 getrennt, die im Belastungsfalle eine viel niedrigere Spannung als die Spannung am Kondensator 96 aufweist. Ein Kondensator 98 dient als sogenannter Anschießkondensator, der in den Pausenzeiten voll aufgeladen wird und beim Auslösen des Schaltverstärkers seine Ladung an diesen abgibt und somit alte Batterien wirksam unterstützt.

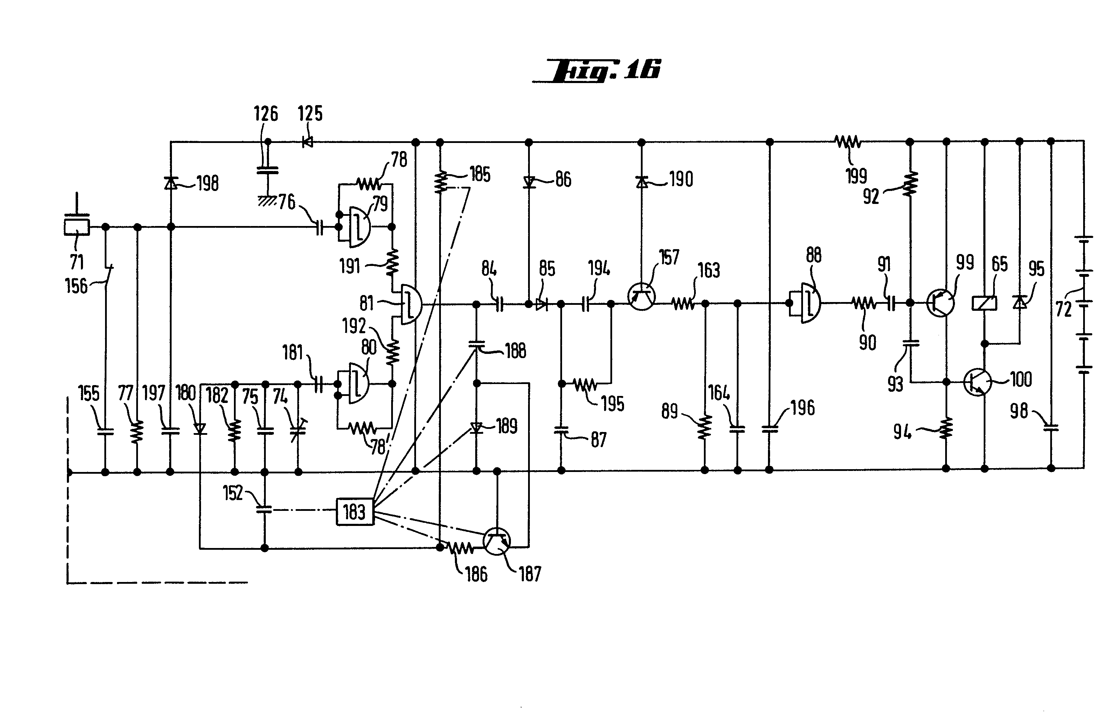

Fig. 15 zeigt ein Schaltbild einer weiteren bevorzugten Ausführungsform. Diejenigen Schaltelemente, die mit der Schaltanordnung gemäß Fig. 14 übereinstimmen, sind mit gleichen Bezugsziffern versehen und werden nicht nochmals beschrieben. Wie ersicht-

-29-

lich, ist bei der Anordnung gemäß Fig. 15 keine Abzweigung der Spannung an dem elektrochemischen Element 72 vorgesehen.

Weiterhin ist bei dieser Ausführungsform eine als Kapazitätsdiode arbeitende Diode 180 dem nicht durch kurzfristige Kapazitätsänderungen beeinflußbaren Oszillator 80 zugeordnet. Sie liegt parallel zu dem Festoszillator 80. Zwischen Diode 180 und dem Festoszillator 80 liegt ein Kondensator 181 und parallel zu dem Trimmerkondensator 74 ein Widerstand 182. Das hier mit 183 bezeichnete Zeitglied weist den Kondensator 151, Widerstände 185, 186 und einen Transistor 187 auf. Der Emitter des Transistors 187 ist mit einem Kondensator 188 und einer Diode 189 verbunden, die zwischen Masse und dem Ausgangssignal des Mischers 81 liegen.

Zwischen den Ausgängen der Oszillatoren 79, 80 und den Eingängen des Mischers 81 liegen Widerstände 191, 192, welche ungleich sind. Vor dem hier mit 157 bezeichneten Verstärkungstransistor liegt ein Kondensator 194 und ein Emitterwiderstand 195. Mit 196 bzw. 197 sind Kondensatoren bezeichnet. Schließlich ist dem variablen Oszillator 79 eine weitere, als Kapazitätsdiode arbeitende Diode 198 zugeordnet, die einerseits mit der Sensorplatte 71 und andererseits mit der positiven Betriebsspannung verbunden ist.

Bei der Schaltung gemäß Fig. 15 ist der Oszillator 79 über den Kondensator 76 durch die Sensorplatte 71 beeinflußbar, derart, daß bei entsprechender Kapazi-

-30-

tätsänderung ein die Ausgabe auslösendes Signal erzeugt wird. Der Oszillator 80 ist eigentlich der Festoszillator, jedoch wirkt die Nachregelung auf diesen Festoszillator derart ein, daß bei einer langfristigen Kapazitätsänderung das Ausgangssignal des Oszillators 80 dem Ausgangssignal des Oszillators 79 im Sinne einer Synchronisierung angepaßt wird. In unbeeinflußtem Zustand schwingen beide Oszillatoren im wesentlichen synchron. Für den Oszillator 79 ist der Widerstand 78, der Kondensator 197, die als Kapazitätsdiode arbeitende Diode 198 sowie die Kapazität der Sensorplatte 71 frequenzbestimmend, wobei die als Kapazitätsdiode arbeitende Diode 198 zum Ausgleich von Spannungs-und Temperaturschwankungen vorgesehen ist. Der Widerstand 77 dient zur Speisung der Diode 198. Die Frequenz des Oszillators 80 wird bestimmt durch den Widerstand 78', den Trimmerkondensator 74 und den Festkondensator 75, der dem Trimmerkondensator 74 zur Bereichseingrenzung parallelgeschaltet ist. Außerdem wird zur Frequenzverschiebung bei langfristigen Änderungen die Kapazitätsdiode 180 benutzt.

Die Ohmschen Widerstände 191 und 192 zur Speisung des Mischers 81 sind ungleich. Durch die daraus resultierende Speisung der Mischstufe mit ungleichen Spannungen wird, wie auch bei Fig. 14 durch die kapazitiven Widerstände 123 und 124, die Regelautomatik des Zeitgliedes 183 dahingehend beeinflußt, daß nach Beendigung einer langfristigen Kapazitätsänderung bzw. Störung am Näherungsschalter eine Rückregelung des Oszillators 80 auf das vor dem Auf-

-31-

treten der Störung abgegebene Niederfrequenzausgangssignal erfolgt.

Das Zeitglied 183 besteht aus dem Trennkondensator
88, aus der Gleichrichterdiode 189, dem Entladetransistor 187, dem Entladewiderstand 186, dem Entladewiderstand 185 und dem Ladekondensator 152. Die
am Ausgang des Mischers 81 im Störungsfalle (Beginn
einer langfristigen Kapazitätsänderung) anstehende
Spannung wird über den Trennkondensator 188 abgezweigt, eine Halbwelle durch die Diode 189 kurzgeschlossen und die andere Halbwelle als Steuerspannung für den Entladetransistor 187 verwendet.

Der Ladekondensator 152 ist bei Ausbleiben einer
Störung über den Widerstand 185 auf ein bestimmtes
Potential aufgeladen. Erfolgt nun eine Störung, so
wird der Entladetransistor 187 leitend, und die
Ladung des Kondensators 152 fließt über den Entladewiderstand 186 und den Entladetransistor 187 nach
Masse ab. Da die frequenzbestimmende, als Kapazitätsdiode wirkende Diode 180 über den Widerstand 182
parallel zum Ladekondensator 152 liegt, verändert
sie ihre Kapazität entsprechend. Durch die sich aus
den Werten des Entladewiderstandes 186 und des Ladekondensators 152 ergebende Zeitkonstante verändert
sich die Spannung an der als Kapazitätsdiode wirkenden Diode 180 nur langsam. Schnelle Störungen, wie
sie sich aus der normalen Benutzung ergeben, ändern
die Regelspannung nur unwesentlich.

Die für den NAND-Schmitt-Trigger 88 und den nach-

-32-

folgenden Schaltverstärker mit den Transistoren 99 und 100 erforderliche Steuerspannung wird über den Kondensator 84 der Gleichrichterdiode 85 zugeführt, während die Gleichrichterdiode 86 die nicht erforderliche Halbwelle kurzschließt. Ein Kondensator 164 ist dem Eingang des NAND-Schmitt-Triggers 88 zugeordnet und verhindert, daß dieser durch Eindringen steiler Fremdimpulse ausgelöst wird.

Der Emittergleichstrom des Verstärkertransistors 157 fließt über die Dioden 85, 86 und den Emitterwiderstand 195. Die Verstärkung des Transistors 157 wird durch das Verhältnis des Emitterwiderstandes 195 zu den Kollektorwiderständen 163 und 89 bestimmt. Das Verhältnis dieser Widerstände ist so gewählt, daß die Gleichstromverstärkung um den Wert 1 oder knapp unter 1 liegt.

Erfolgt nun eine Bedienung der Ausgabevorrichtung durch eine kurzfristige Kapazitätsstörung, so erscheinen die Impulsflanken dieser Störung an dem Kondensator 194, der sie zum Emitter des Transistors 157 weiterleitet und der für diese Impulsflanken einen niedrigeren Emitterwiderstand darstellt. Dadurch wird das Verhältnis zwischen Emitterwiderstand 195 und den Kollektorwiderständen 163, 89 des Verstärkungstransistors 157 so verändert, daß dieser seine Verstärkung schlagartig erhöht und den Impuls kräftig verstärkt. Hierdurch kann der NAND-Schmitt-Trigger 88 durchschalten und den nachfolgenden Schaltverstärker ansteuern.

-33-

Um nach Beendigung der Bedienungsaktion ein sofortiges Schalten des Verstärkungstransistors 157 in die nicht leitende Stellung (Ruhestellung) zu bewirken, wird der Basis des Verstärkungstransistors 157 über den Kondensator 160 eine steile Impulsflanke zugeführt. Die Diode 190 verhindert ein Abfließen dieses Impulses. Dadurch wird der Basis des Verstärkertransistors 157 eine derartige Spannung zugeführt, daß er schlagartig gesperrt wird.

Die NAND-Schmitt-Trigger 79, 80, 81 und 88 sind insgesamt als IC ausgebildet. Dieser IC wird aus dem Kondensator 196 gespeist, der seinerseits über den relativ hochohmigen Vorwiderstand 199 geladen wird. Der Strom des IC's ist im Verhältnis zum Strom des Schaltverstärkers sehr gering. Wenn der Schaltverstärker durchschaltet, bricht die Spannung vor allem bei älteren Batterien an deren Innenwiderstand zusammen, und die Spannung am Kondensator 196 und damit am IC würde unzulässig niedrig werden, was zu Betriebsstörungen führen könnte. Der Vorwiderstand 199 lädt in den Pausenzeiten den Kondensator 196 auf die Leerlaufspannung der Batterien 72 auf und verhindert beim Zusammenbrechen der Batteriespannung während der Betätigung des Schaltverstärkers ein schnelles Abfließen der Ladung des Kondensators 196, so daß die Spannung am IC relativ konstant bleibt.

Der Fig. 16 ist in Abweichung von Fig. 15 zu entnehmen, daß zwischen die Kapazitätsdiode 198 und den Widerstand 199 eine Sperrdiode 125 geschaltet ist und die Sperrdiode 125 über einen Haltekondensator

-34-

126 gegen Masse liegt. Durch diese Schaltung wird bei Abfallen der Betriebsspannung durch eine Betätigung die Spannung an der Kapazitätsdiode so lange gehalten, bis die Betriebsspannung wieder ihren vollen Wert erreicht hat.

-35-

Patentansprüche

1. Durch Gleichspannung mittels eines kapazitiven Näherungsschalters betätigbare Ausgabevorrichtung für flüssige oder pastöse Güter, wie Desinfektions- und Putzmittel, Seife und Salben, bei der der Näherungsschalter eine Sensorschaltung mit zwei in Ruhestellung im wesentlichen synchron schwingenden Oszillatoren aufweist, und das Schwingungsverhalten mindestens eines der Oszillatoren durch eine von dem Näherungsschalter erfaßbare Kapazitätsänderung veränderbar ist und bei einer bestimmten Schwingungsdifferenz der Oszillatoren ein die Ausgabe auslösendes Signal erzeugt wird, dadurch gekennzeichnet, daß eine Regelvorrichtung vorgesehen ist, bei der die Oszillatorausgangssignale einen Mischer (81) mit ungleicher Spannung beaufschlagen.

2. Ausgabevorrichtung nach Anspruch 1, dadurch gekennzeichnet, daß dem Mischer (81) ungleiche Widerstände (191, 192) vorgeschaltet sind.

3. Ausgabevorrichtung nach einem der Ansprüche 1 und 2, dadurch gekennzeichnet, daß dem Mischer

-36-

(81) als ungleiche Widerstände (191, 192) zwei kapazitive Widerstände (123, 124) ungleicher Kapazität vorgeschaltet sind.

4. Ausgabevorrichtung nach einem der Ansprüche 1 bis 3, dadurch gekennzeichnet, daß die Regeleinrichtung beiden Oszillatoren (79, 80) zugeordnet ist.

5. Ausgabevorrichtung nach einem der Ansprüche 1 bis 3, dadurch gekennzeichnet, daß das Ausgangssignal eines der Oszillatoren (80) durch eine langfristige Kapazitätsänderung und das Ausgangssignal des anderen Oszillators (79) durch eine kurzfristige Kapazitätsänderung beeinflußbar ist.

6. Ausgabevorrichtung nach einem der Ansprüche 1 bis 5, dadurch gekennzeichnet, daß einer der Oszillatoren (79, 80) als Festoszillator (80) und der andere der Oszillatoren (79, 80) als durch langfristige und kurzfristige Kapazitätsänderungen beeinflußbarer Oszillator (79) ausgebildet ist.

7. Ausgabevorrichtung nach einem der Ansprüche 1 bis 6, dadurch gekennzeichnet, daß die Regeleinrichtung ein Zeitglied (183, 151) aufweist.

8. Ausgabevorrichtung nach einem der Ansprüche 1 bis 7, dadurch gekennzeichnet, daß die Regeleinrichtung eine als Kapazitätsdiode arbeitende

0152735

-37-

Diode (150 bzw. 180) aufweist.

9. Ausgabevorrichtung nach einem der Ansprüche 1
bis 8, dadurch gekennzeichnet, daß dem Mischer
(81) ein Verstärkertransistor (157, 193) nachgeschaltet ist.

10. Ausgabevorrichtung nach einem der Ansprüche 1
bis 9, dadurch gekennzeichnet, daß die Sensorschaltung vier NAND-Schmitt-Trigger enthält, wobei zwei als Oszillatoren (79, 80), der dritte
als Mischer (81) und der vierte als Schwellwertschalter (88) geschaltet sind.

11. Ausgabevorrichtung nach einem der Ansprüche 1
bis 10, dadurch gekennzeichnet, daß dem Ladekondensator (152) des Zeitgliedes (151) eine
Entladediode (154) zugeordnet ist.

12. Ausgabevorrichtung nach einem der Ansprüche 1
bis 11, dadurch gekennzeichnet, daß dem Verstärkertransistor (157) am Basiseingang eine
Zenerdiode (159) zugeordnet und zwischen dem
Ladekondensator (152) und dem vierten
NAND-Schmitt-Trigger (88) eine Schaltdiode (161)
mit einem Widerstand (162) geschaltet ist.

13. Ausgabevorrichtung nach einem der Ansprüche 1
bis 9, dadurch gekennzeichnet, daß die als Kapazitätsdiode arbeitende Diode (180) parallel zu
dem nicht durch kurzfristige Kapazitätsänderungen beeinflußbaren Oszillator (80) liegt und eine Nachregelung dieses Oszillators bewirkt.

14. Ausgabevorrichtung nach einem der Ansprüche 1 bis 9 und Anspruch 13, dadurch gekennzeichnet, daß dem auf kurzfristige Kapazitätsänderungen ansprechenden Oszillator (79) zum Zwecke des Ausgleichs von Spannungs- und Temperaturschwankungen eine weitere, als Kapazitätsdiode wirkende Diode (198) zugeordnet ist.

15. Ausgabevorrichtung nach einem der Ansprüche 1 bis 13, dadurch gekennzeichnet, daß zwischen Kapazitätsdiode (198) und Widerstand (199) eine Sperrdiode (125) geschaltet ist und daß zwischen Sperrdiode (125) und Kapazitätsdiode (198) ein Haltekondensator (126) gegen Masse liegt.

16. Ausgabevorrichtung nach einem der Ansprüche 1 bis 15, dadurch gekennzeichnet, daß das Verhältnis des Emitterwiderstandes (195) zu den Kollektorwiderständen (89, 163) des Verstärkungstransistors (157) derart ist, daß die Gleichstromverstärkung um 1 oder knapp unter 1 liegt und in dem Emitterkreis des Verstärkertransistors (157) ein Kondensator (194) liegt.

17. Ausgabevorrichtung nach einem der Ansprüche 1 bis 16, dadurch gekennzeichnet, daß ein Impuls am Ausgang des NAND-Schmitt-Triggers (88) über einen Kondensator (160) der Basis des Verstärkungstransistors (157) zuführbar ist.

**Fig. 1**

Fig. 2

**Fig. 3**

_Fig. 4._

**Fig.5**

**Fig.6**

**Fig.7**

**Fig.9**

**Fig.8**

0152735

0152735

Fig.11

Fig.10

**Fig.13**

**Fig.12**

Fig. 14

9/11

0152735

Fig. 15

10/11

0152735

Fig. 16

11/11

0152735

# EUROPÄISCHER RECHERCHENBERICHT

**Europäisches Patentamt**

0152735
Nummer der Anmeldung

EP 85 10 0081

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | CH-A- 584 981 (M. BAUMGARTNER) <br> * Spalte 2, Zeilen 13-33; Figuren 1,2 * | 1,2,4 | H 03 K 17/955 |
| X | US-A-3 510 677 (G.H. LISTER) <br> * Spalte 2, Zeilen 43-45; Spalte 4, Zeilen 44-52; Spalte 5, Zeilen 41-49; Spalte 7, Zeilen 5-66; Figuren 1-3 * | 1,4-6 | |
| Y | * Spalte 3, Zeilen 72-75; Spalte 4, Zeilen 1-2; Spalte 4, Zeilen 25-30 * | 14 | |
| X | FUNKSCHAU, Band 52, Nr. 1, Januar 1981, Seiten 97-98, München, DE; H. FEICHTINGER: "Kapazitiver Annäherungs-Schalter" * Insgesamt * | 1,4,6, 10 | **RECHERCHIERTE SACHGEBIETE (Int. Cl.4)** <br><br> H 03 K |
| X | DE-A-2 538 531 (SIEMENS AG) <br><br> * Ansprüche 2-5; Figur 1 * | 1,4,6, 8 | |
| A | DE-A-1 810 653 (TATEISI ELECTRONICS CO.) <br> * Seite 6, letzter Absatz; Seite 8, Zeilen 7-10; Figuren 1,2 * | 7,8,11 ,13 | |
| | --- -/- | | |

Der vorliegende Recherchenbericht wurde für alle Patentansprüche erstellt.

| Recherchenort <br> DEN HAAG | Abschlußdatum der Recherche <br> 21-05-1985 | Prüfer <br> ARAN D.D. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein-stimmendes Dokument

EPA Form 1503 03 82

**Europäisches Patentamt**

**EUROPÄISCHER RECHERCHENBERICHT**

0152735
Nummer der Anmeldung

EP 85 10 0081

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | * Seite 3, Zeilen 4-8 * <br> --- <br> ----- | 14 | |

RECHERCHIERTE SACHGEBIETE (Int. Cl.4)

Der vorliegende Recherchenbericht wurde für alle Patentansprüche erstellt.

| Recherchenort <br> DEN HAAG | Abschlußdatum der Recherche <br> 21-05-1985 | Prüfer <br> ARAN D.D. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82